# EUROPEAN PATENT SPECIFICATION

(11) **EP 1 987 587 B1**
(45) Date of publication and mention of the grant of the patent: **30.09.2015**
(21) Application number: 07705262.9
(22) Date of filing: 26.02.2007
(51) Int. Cl.: H03J 1/00

(54) **TUNING OF RADIO RECEIVERS**
ABSTIMMUNG VON FUNKEMPFÄNGERN
SYNTONISATION DE RECEPTEURS RADIO

(30) Priority: 24.02.2006 GB 0603807
(43) Date of publication of application: 05.11.2008
(73) Proprietor: Sound Decisions Ltd., Walworth Industrial Estate Andover SP10 5NX (GB)
(72) Inventor: OPPERMAN, Nicholas, Richard, James, Andover SP10 5NX (GB)
(74) Representative: Chapman, Helga Claire
(86) International application number: PCT/GB2007/000631
(87) International publication number: WO 2007/096634

(56) References cited:
- EP-A- 0 513 477
- GB-A- 2 381 397

## Description

This invention reflates to radio receivers and in particular to the tuning of radio receivers. The invention was conceived for use with radio receivers intended for receiving "event radio", but it may have other applications.

Event radio began as the radio broadcasting of a commentary or other audio information at a sports event so that spectators at the event can receive that information. As a result, a spectator can receive expert commentary and information regarding the event they are quite probably paying to watch and is no longer discriminated against when compared to a TV viewer. Some event types lend themselves to event radio more obviously than others, such as:
- those where much of the action takes place out of sight of the spectator (e.g. motorsports, three-day eventing, golf, yachting etc.);
- those where traditional public address is difficult due to ambient noise or distance (e.g. airshows etc.);
- those where traditional public address is simply not acceptable (e.g. golf, cricket, snooker etc.);
- those where the spectators can see the action, but want to know what is going on at associated events (e.g. rugby and football league matches); and
- those where expensive displays, such as TV monitors or "jumbotrons", are currently available to spectators but without an audio stream (e.g. horse racing, rugby and football league matches etc.).

Event radio has also been employed to assist those who are hard of hearing, for example in the theatre.

A radio receiver for receiving event radio is disclosed in patent document GB2381397A. It is a natty little device having a housing and a hooked element that enables the housing to be worn on the user's ear. The housing contains a battery, radio receiver circuit, speaker, volume control and on-off switch. An antenna for the receiver circuit is contained in a lanyard connected to the housing to enable the user to hang the device around their neck when they are not listening to it. In an early commercially-produced version of the device, the radio receiver was tuned to a preset reception frequency. In a later version of the device, the user can change the reception frequency by pressing a "scan" button on the housing. Upon pressing the button, the device scans from the current reception frequency through the reception band until the next strong signal is received. The device can therefore advantageously be used at different events to receive event radio being broadcast on different frequencies and can also be used to receive the broadcasts from any other radio stations broadcasting in the particular band.

In the United Kingdom and many other countries, commercial FM radio is broadcast in the 87.5 to 108.0 MHz FM2 band, and event radio has traditionally used the same band. However, other frequencies have more recently been made available for use by event radio and disabled assisted listening, such as frequencies in the 60 to 62 MHz spectrum and in the 72 to 76 MHz spectrum.

The invention relates more particularly to a radio receiver having means operable by a user to change the reception frequency to which the receiver is tuned and having first and second modes of operation, selectable by the user. The receiver is arranged so that at least immediately after the first mode is selected, the frequency changing means is operable in a defined manner by the user to tune the receiver to any desired frequency in a first band of reception frequencies (e.g. the 87.5 to 108.0 MHz band) and/or to the frequency of any desired signal being received in the first band of frequencies. However, at least immediately after the second mode is selected, the receiver is tuned to a preset frequency outside of the first band. Such a receiver is known, for example from patent document EP0513477A.

A first aspect of the present invention is characterised in that, at least immediately after the second mode is selected, operation of the frequency changing means in the defined manner is ineffective. This aspect of the invention is suitable for use where the receiver is intended to receive event radio on only one frequency outside of the first band. This aspect of the invention has the advantage that, when the user wishes to change between listening to a broadcast in the first band and listening to the event radio broadcast outside the first band, the user does not need to scan the tuning of the radio between the event radio frequency and the frequency of the other broadcast, something that could take a considerable time when changing for example from 60.0 to 108.0 MHz. Preferably, when the second mode is selected, the receiver cannot be tuned by the user to any frequency other than the preset frequency. This has the advantage that the user cannot tune the receiver to frequencies (which may be prohibited frequencies) between the event radio frequency and the first band.

A second aspect of the invention is characterised in that, at least immediately after the second mode is selected, the frequency changing means is operable in the defined manner to tune the receiver to any one of a plurality of preset frequencies at least one of which is outside of the first band. This aspect of the invention is suitable for use where the receiver is intended to receive event radio on at least two frequencies (at least one of which is outside of the first band). Again, this aspect of the invention has the advantage that, when the user wishes to change between listening to a broadcast in the first band and listening to the event radio broadcast outside the first band, the user does not need to scan the tuning of the radio between the event radio frequency and the frequency of the other broadcast.

Preferably, when the second mode is selected, the receiver cannot be tuned by the user to any frequency other than one of the plurality of preset frequencies. Again, this has the advantage that the user cannot tune the receiver to frequencies (which may be prohibited frequencies) between the event radio frequency and the first band.

Preferably, when the second mode is selected, the receiver cannot be tuned by the user to at least one of the preset frequencies in accordance with an indication stored by the receiver. For example, if the receiver has the facility to store, say, eight preset frequencies but only, say, five of them are to be used, the receiver may also store an indication that only the first five preset frequencies are to be used, or three of the preset frequencies may be set to a particular value (e.g. 0.00 MHz), and the receiver will operate to prevent tuning to the last three preset frequencies, or to the preset frequencies having the particular value.

The frequency changing means preferably comprises first and second elements (e.g. push-buttons) operable by the user, and the defined manner of operation of the frequency changing means comprises: operating the first element when the first mode is selected to increase the reception frequency in the first band (e.g. by scanning and/or frequency-stepping); operating the second element when the first mode is selected to decrease the reception frequency in the first band (e.g. by scanning and/or frequency-stepping); and operating the first and second elements when the second mode is selected to change the selection of preset frequency. More particularly, in the case where, when the second mode is selected, the frequency changing means is operable in the defined manner to tune the receiver to more than two such preset frequencies, the defined manner of operation of the frequency changing means preferably includes: operating the first element when the second mode is selected to change the selection of preset frequency in one sequence (e.g. in the case of three preset event radio frequencies, from the first preset frequency to the second, and then from the second preset frequency to the third); and operating the second element when the second mode is selected to change the selection of preset frequency in an opposite sequence (e.g. from the first preset frequency to the third, and then from the third preset frequency to the second). In this case, the selected mode can preferably changed by the user by operating both elements simultaneously. Accordingly, using only two buttons, it is possible to change between the two modes and to tune the receiver in the current mode.

With either aspect of the invention, the receiver is preferably arranged so that, when the receiver is initially switched on, the second mode is initially selected. Event radio receivers are often sold, or given away, at events where event radio is being broadcast, and therefore all the user has to do is to switch on the receiver to receive event radio, without having to worry about mode selection. In the case of the second aspect of the invention, the receiver is preferably arranged so that, when the receiver is initially switched on, the receiver is initially tuned to a preset or predetermined one of the preset frequencies, which is preferably the frequency of the broadcast for the event for which the receiver is acquired. The receiver is preferably also arranged so that, when at least one of the modes is re-selected, the receiver is initially tuned to the frequency to which it was tuned when that mode was last selected. If this feature is provided for both bands, and if, during a break during an event, a user tunes in the first mode to their favourite radio station, when they subsequently select the second mode at the end of the break, the receiver will automatically tune to the relevant event radio broadcast. If, during a subsequent break, the user selects the first mode again, the receiver will automatically tune to the user's favourite radio station.

In order to prevent distorted output from the receiver, when the second mode is selected, the receiver may be operable to disable its output when a received signal has a signal strength less than a preset threshold.

When the second mode is selected, the receiver may be operable to disable its output when a received signal does not include a particular code. Therefore, if an event radio broadcaster adds the particular code to the event radio signals that they broadcast, this feature prevents the receiver being used to receive event radio broadcast by a different broadcaster who does not add the particular code to their broadcasts.

In the manner suggested in patent document GB2381397A, the radio receiver is preferably provided by a radio receiver circuit having an aerial input and a speaker output, wherein: the circuit is contained in a housing; a hooked element extends from the housing for hanging the housing on a user's ear; a speaker is contained in the housing and connected to the speaker output of the receiver circuit for directing sound at the user's ear when the housing is worn on the user's ear; a lanyard extends from the housing by which the user can hold the receiver and/or hang the receiver around their neck; and the lanyard forms or contains an aerial connected to the aerial input of the receiver circuit.

The lanyard provides a useful advertising tool, since it can be printed or interwoven with advertising material relevant to the event for which the radio receiver is being supplied. However, a problem arises in that assembly of a particular batch of receivers typically has to wait until the lanyards have been produced, and that takes time. Furthermore, if some of the receivers that have been produced for a particular event are not used, they then either need to be scraped, or taken apart and fitted with different lanyards for a subsequent event. This is wasteful of time and/or resources.

The lanyard and aerial are therefore preferably mechanically connected to the housing and electrically connected to the aerial input by a releasable connection so that that lanyard and aerial can be removed from the housing and replaced by a different lanyard and aerial.

Specific embodiments of the present invention will now be described, purely by way of example, with reference to the accompanying drawings, in which:
- Figure 1: is a perspective view of a radio receiver of a first embodiment of the invention;
- Figure 2: is a side view of the receiver of Figure 1;
- Figure 3: is an electrical block diagram of the receiver of Figure 1;
- Figure 4: is a flow diagram of the operation of a microcontroller in the receiver of Figure 1;
- Figures 5 & 6: are flow diagrams of modified operations of the microcontroller in the receiver of Figure 1;
- Figure 7: is a side view of a radio receiver of a second embodiment of the invention, with its lanyard detached;
- Figure 8: is a front view of the radio receiver of Figure 7;
- Figure 9: is a partial underplan view, on a larger scale, of the receiver of Figure 7, with its lanyard removed;
- Figure 10: is an end view of a connector of the lanyard of the radio receiver of Figure 7;
- Figure 11: is a partial sectioned side view of the receiver of Figure 7, with its lanyard attached; and
- Figure 12: is a partial sectioned front view of the receiver of Figure 7, with its lanyard attached.

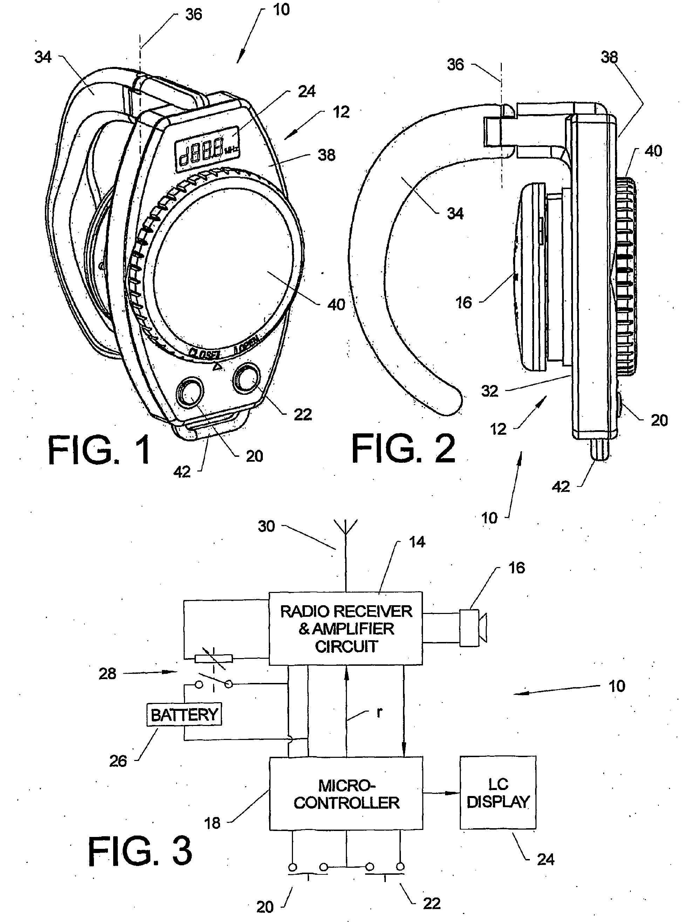

Referring to Figures 1 to 3, the first embodiment of radio receiver 10 that is intended to be used with the receiver 10 worn on a user's, ear comprises:
- a housing 12 containing:
   ∘ a radio receiver and amplifier circuit 14 which can receive audio radio in the frequency range 60.0 to 108.0 MHz and is tunable in 0.1 MHz steps;
   ∘ a speaker 16 connected to the output of the circuit 14;
   ∘ a microcontroller 18 for setting the reception frequency of the circuit 14 and detecting the signal strength of the received signal;
   ∘ a pair of user operable push-button switches 20,22 for controlling the microcontroller 18, one of the switches 20 being designated an "up" switch, and the other 22 a "down" switch;
   ∘ a liquid crystal display 24 for displaying the reception frequency or channel of the circuit 14;
   ∘ a button-cell battery 26 for powering the circuitry in the housing 12; and
   ∘ a combined on-off switch and potentiometer 28 for switching the receiver 10 on and off and for setting the output volume of the speaker 16; and
- an antenna 30 for the circuit 14.

The majority of the circuitry of the radio receiver and amplifier circuit 14 and microcontroller 18 is preferably implemented using a single application specific integrated circuit (ASIC).

The speaker 16 faces out from a rear face 32 of the housing 12 and may be covered by a foam rubber cover (not shown). A hooked element 34 is hinged to the top of the rear face 32 of the housing 12 and can be pivoted about an axis 36 between one position in which the receiver 10 can be worn on the user's right ear with the speaker 16 facing the right ear and the hooked element hooked over the top of the right ear and extending down the back of the ear, and an opposite position in which the receiver 10 can be worn on the user's left ear with the speaker 16 facing the left ear and the hooked element hooked over the top of the left ear and extending down the back of the ear. A central portion of a front face 38 of the housing 12 is provided by a removable cover 40 to provide access to the battery 26. The liquid crystal display 24 is disposed above the battery cover 40, and the push-buttons of the switches 20,22 are disposed beneath the battery cover. The combined switch and potentiometer 28 has a thumbwheel that is accessible through one edge of the housing 12 (but is not in view in Figures 1 and 2). The antenna 30 is provided in a lanyard (not shown) that is attached to a lug 42 on the bottom edge of the housing 12. Further description of the lanyard antenna can be found in patent document GB2381397A.

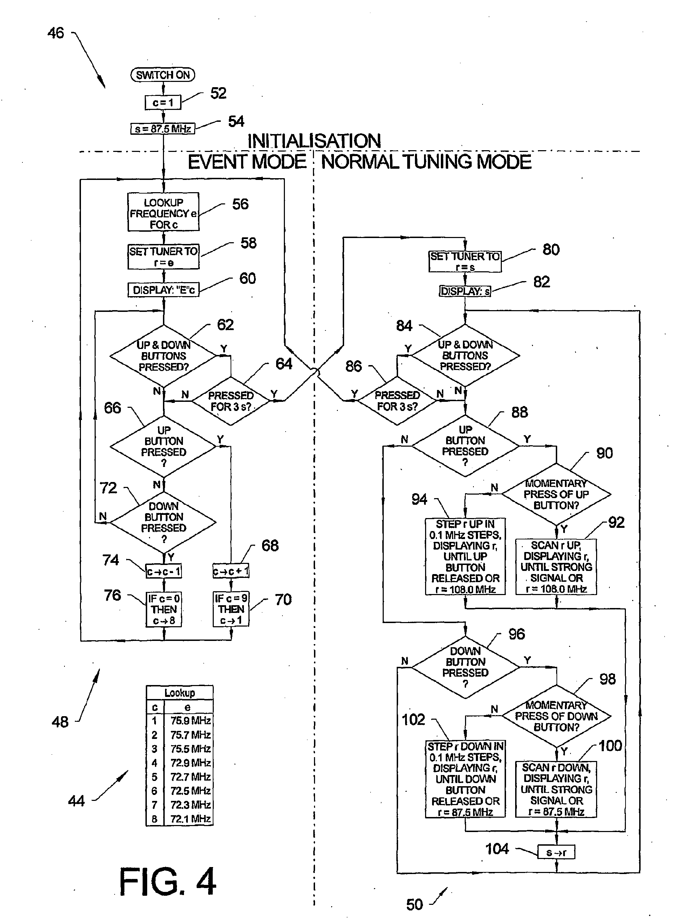

The microcontroller 18 includes a processor, working memory and non-volatile memory. The non-volatile memory stores the operating program of the microcontroller 18 and also preset event radio reception frequencies which can be considered to be in the form of a lookup table 44 (Figure 4). The microcontroller 18 receives user input from the switches 20,22 and supplies an output *r* to the radio receiver and amplifier circuit 14 indicative of the required reception frequency to which the circuit 14 is to be tuned.

The operation of the microcontroller 18 will now be described with reference to Figure 4. The flow diagram of Figure 4 has three portions:
- an initialisation portion 46 which is processed when the receiver 10 is first switched on;
- an event mode portion 48 which is processed immediately after the initialisation portion 46 and which defines the operation of the microcontroller 18 when in "event mode"; and
- a normal tuning mode portion 50 which defines the operation of the microcontroller 18 when in "normal tuning mode"; the microcontroller 18 can be toggled between event mode and normal tuning mode by the user as will be described in greater detail below.

The flow diagram employs four parameters as follows that are stored in the volatile memory of the microcontroller 18:
*c* the current event radio channel number, which in the example is in the range 1 to 8;
*e* the current event radio frequency, which is given by the lookup table 44 from the event radio channel number *c*;
*s* the current normal tuning frequency, which in the example is in the range 87.5 MHz to 108.0 MHz; and
*r* the frequency to which the radio receiver and amplifier circuit 14 is to be tuned, which is either the current event radio frequency *e* when in event mode, or the current normal tuning frequency *s* when in normal tuning mode.

In the initialisation portion 46 of the flow diagram of Figure 4, when the receiver 10 is first switched on, the current event radio channel number *c* is set to "1" in step 52 and the current normal tuning frequency *s* is set to 87.5 MHz in step 54. The flow then enters the event mode portion 48.

In the event mode portion 48 of the flow diagram of Figure 4, the lookup table 44 is used, in step 56, to look-up the current event radio frequency *e* for the current event radio channel number *c*. The reception frequency *r* is then set, in step 58, equal to the current event radio frequency *e* so that the circuit 14 tunes to that frequency. The display 24 is also set, in step 60, to display "E" *c*, for example "E1". The microcontroller 18 then tests, in step 62, whether the buttons of both switches 20,22 are being pressed, and if so, in step 64, whether they have both been pressed for 3 seconds. If so, the flow moves to the normal tuning mode portion 50. However, if either test 62,64 is negative, the microcontroller 18 then tests, in step 66, whether the button of the up switch 20 is being pressed. If so, in steps 68,70, the current event radio channel number c is incremented (or if it is "8", it is changed to "0"), and then the flow returns to step 56. If not, the microcontroller 18 then tests, in step 72, whether the button of the down switch 22 is being pressed. If so, in steps 74,76, the current event radio channel number c is decremented (or if it is "1", it is changed to "8"), and then the flow returns to step 56. If not, then the flow returns to step 62. It will be appreciated that, following a positive test in step 66 or 72 and changing of the current event radio channel number *c* in steps 68,70,74,76, the tuning of the circuit 14 and display of the current radio channel number *c* will be updated in the subsequent steps 56,58,60. Accordingly, the buttons of the switches 20,22 can be pressed individually to change up and down the number of the event radio channel to which the receiver 10 is tuned, and can be pressed simultaneously to change to normal tuning mode.

In the normal tuning portion 50 of the flow diagram of Figure 4, the reception frequency *r* is set, in step 80, equal to the current normal tuning frequency *s* so that the circuit 14 tunes to that frequency. The display 24 is also set, in step 82, to display that frequency, for example "87.5". The microcontroller 18 then tests, in step 84, whether the buttons of both switches 20,22 are being pressed, and if so, in step 86, whether they have both been pressed for 3 seconds. If so, the flow moves to the event radio mode portion 48. However, if either test 84,86 is negative, the microcontroller 18 then tests, in step 88, whether the button of the up switch 20 is being pressed. If so, the microcontroller 18 then tests, in step 90, whether the button of the up switch 20 has been pressed momentarily (e.g. for less than 0.2 seconds). If so, then in step 92, the microcontroller 18 scans the reception frequency *r* upwardly, displaying the current frequency as it does, until either a strong signal is received or the reception frequency *r* reaches 108.0 MHz. If not, then in step 94, the microcontroller 18 steps the reception frequency *r* upwardly in 0.1 MHz steps, displaying the current frequency as it does, until either the button of the up switch 20 is released or the reception frequency *r* reaches 108.0 MHz. If, in step 88, it is determined that the button of the up switch 20 is not being pressed, the microcontroller 18 then tests, in step 96, whether the button of the down switch 22 is being pressed. If so, the microcontroller 18 then tests, in step 98, whether the button of the down switch 22 has been pressed momentarily (e.g. for less than 0.2 seconds). If so, then in step 100, the microcontroller 18 scans the reception frequency *r* downwardly, displaying the current frequency as it does, until either a strong signal is received or the reception frequency *r* reaches 87.5 MHz. If not, then in step 102, the microcontroller 18 steps the reception frequency *r* downwardly in 0.1 MHz steps, displaying the current frequency as it does, until either the button of the down switch 22 is released or the reception frequency r reaches 87.5 MHz. After step 92, 94, 100 or 102, the normal tuning frequency *s* is set in step 104 equal to the current reception frequency r and the flow then returns to step 84. If the test of step 96 is negative, the flow also returns to step 84. Accordingly, like some conventional radio receivers, the buttons of the switches 20,22 can be pressed individually to cause the receiver 10 to scan upwardly or downwardly in the 87.5 to 108.0 MHz band for the next strong signal, or to cause the receiver 10 to step upwardly or downwardly in the 87.5 to 108.0 MHz band in 0.1 MHz steps. However, unlike a conventional radio receiver, the buttons of the switches 20,22 can be pressed simultaneously to change to event radio mode.

It should also be noted that, upon a return to the event radio mode 48, the receiver 10 tunes to the event radio channel *c* to which it was last tuned when in event radio mode, and, upon a return to the normal tuning mode 50, the receiver 10 tunes to the frequency *s* of the radio station to which it was last tuned when in normal tuning mode. It should furthermore be noted that, when the receiver 10 is initially turned on, it is initially tuned as a result of steps 52,56,58 to the first frequency listed in the lookup table 44 (75.9 MHz in the example given). In the case where the receiver 10 is supplied for use at a particular event for which event radio is to be broadcast on a particular frequency, that frequency may be stored as the first frequency in the lookup table 44 so that when the receiver 10 is initially switched on it automatically tunes to the relevant event radio broadcast.

Although the frequencies *e* listed in the lookup table 44 in Figure 4 are all outside the 87.5 to 108.0 MHz band, it will be appreciated that some of the event radio frequencies *e* may be within the 87.5 to 108.0 MHz band.

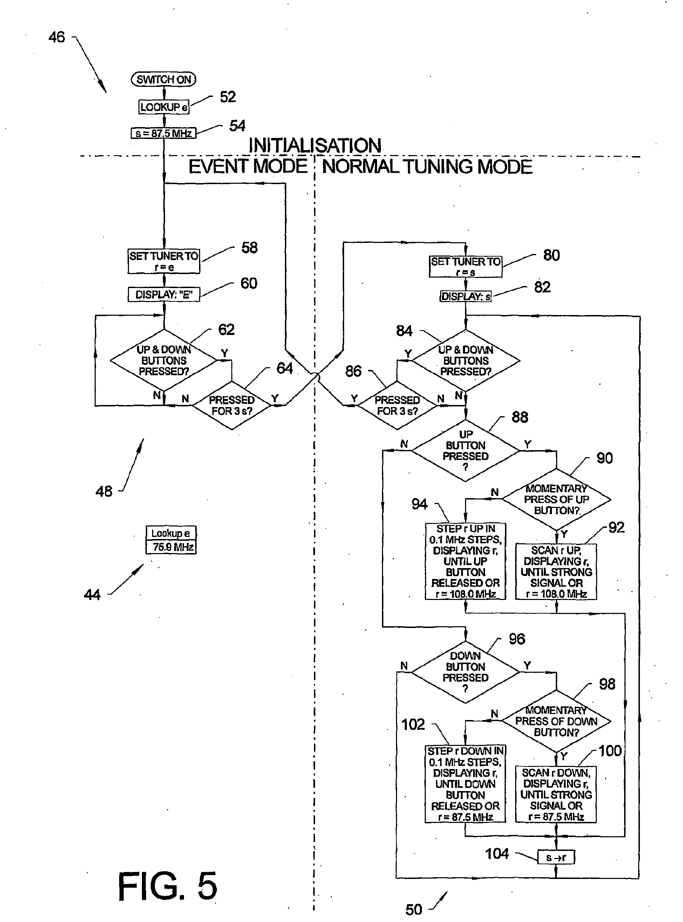

Figure 5 shows a modification to the flow diagram of Figure 4 in which provision is made for only one event radio channel which is outside of the 87.5 to 108.0 MHz band. Accordingly, the lookup table 44 contains only one entry of an event radio frequency *e*. In the initialisation portion, in step 52, the event radio frequency *e* is looked up from the lookup table 44. In step 60, the display that is provided is merely "E". Steps 56, 58 and 66 to 76 are omitted. In the event that the test of step 62 or 64 is negative, the flow returns to step 62. Otherwise the flow is similar to that described above with reference to Figure 4.

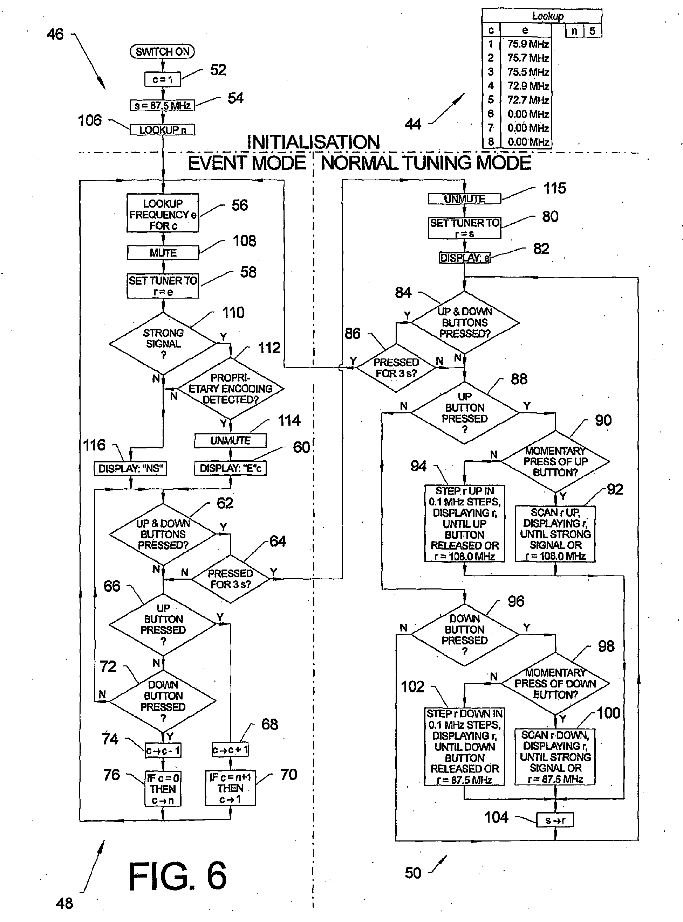

Figure 6 shows a further modification to the flow diagram of Figure 4 that provides the following features:
- less than the maximum number of event radio frequencies *e* may be stored, and the receiver 10 does not attempt to tune to event radio transmissions for which no frequency has been stored;
- the receiver 10 is muted if the received signal strength for an event radio frequency to which the receiver 10 is tuned does not exceed a threshold; and
- the receiver 10 is muted if the received event radio signal does not include a particular code, which may, for example, be specific to a particular event radio broadcaster, so that the receiver 10 cannot be used to listen to broadcasts by other event radio broadcasters.

Specifically, the non-volatile memory 44 also stores a parameter *n* indicative of the number of event radio channels *c* that are stored in the lookup table 44 and intended to be usable. In the initialisation portion 46 of the flow diagram of Figure 6, an additional step 106 is included, after step 54, in which the number of channels *n* is looked up. In the event mode portion 48 of the flow diagram, the step 76 is modified so that if the channel number *c* is decremented from "1", it is changed to *n*, rather than "8". Also, the step 70 is modified so that if the channel number *c* is incremented to *n*+1, rather than "9", it is changed to "1".

Furthermore, in the event radio portion 46 of the flow diagram, the additional step 108 is added, before step 58, in which the receiver 10 is muted before it is tuned to a different frequency *r*. Then, after step 58, two additional steps 110,112 are added. In step 110, it is determined whether the strength of the received signal exceeds a predetermined threshold. In step 112, it is determined whether the received radio signal includes a particular code. The encoding may be added to a subcarrier tone for example as RDS data. If the tests in steps 110,112 are both passed, then in step 114, the receiver 10 is unmuted, and then the process proceeds to steps 60,62 as in Figure 4. However, in Figure 6, if either of the tests in steps 110,112 is failed, in step 116 an error message such as "NS" meaning "no service" is displayed, and then the process proceeds to step 62 with the receiver 10 still muted. As before, in steps 62 to 76, the receiver 10 awaits the pressing of the up and/or down buttons. In the normal tuning mode portion 50 of the flow diagram, an initial step 115 is added to ensure that the receiver 10 is not muted at the beginning of the normal tuning mode process.

Various modifications and developments may be made to the first embodiment of receiver 10 described above. For example, although when in normal tuning mode 50, provision is made for both scan tuning (steps 92,100) and step tuning (steps 94,102) in the embodiment described above, only one of these forms of tuning may alternatively be provided.

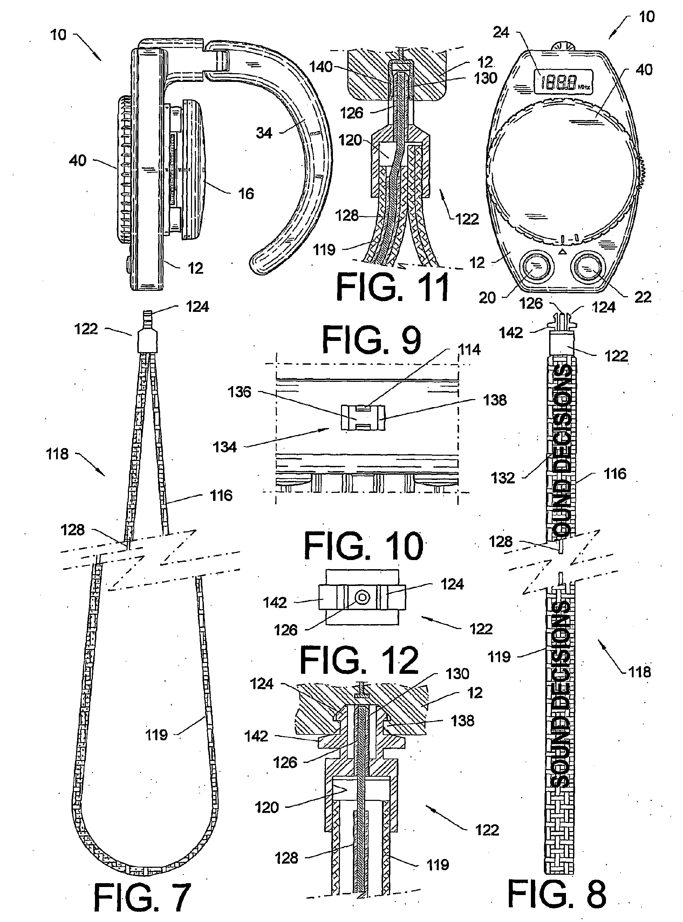

The second embodiment of radio receiver 10 will now be described with reference to Figures 7 to 12. It is identical to the receiver 10 described above with reference to Figures 1 to 6, except in the manner in which the antenna 30 is connected to the receiver 10. The antenna 30 of Figures 7 to 12 forms part of a lanyard 116, as described in patent document GB2381397A, but with the additional feature that the lanyard 116 and antenna 30 assembly 118 can be removed from the receiver 10 and replaced by a different assembly 118.

Specifically, the lanyard 116 comprises a flattened sleeve 119 of flexible woven material, both ends of which are bonded into a recess 120 in a moulded plastics body of a connector plug 122. A pair of oppositely-facing claws 124 extend from the plug 122 facing away from the recess 120. A hollow metal pin 126 is moulded into the plug 122 and projects therefrom between the claws 124. The antenna 30 comprises a flexible wire 128 having one end 130 that is electrically connected inside the pin 126. The antenna wire 128 extends into one end of the sleeve 119 and through the sleeve 119 for about half of its length. The exterior of the sleeve 119 may be printed or interwoven with advertising material 132.

The connector plug 122 is arranged to be releasably connected mechanically and electrically with a complementary socket 134 in the lower edge of the receiver housing 12. The socket 134 is formed as a generally-rectangular recess 136 with claw formations 138 on one pair of opposite sides thereof. A pair of contact blades 140 are disposed against the other pair of opposite sides of the recess 136. The contact blades 140 are electrically interconnected and connected to the antenna input of the radio receiver and amplifier circuit 14.

The plug 122 and socket 134 are arranged so that the plug 122 can be pushed into the socket 134, and so that when the plug 122 is home, each claw 124 of the plug 122 engages with a respective claw formation 138 to lock the plug 122 in the socket 134, and the contact blades 140 connect to the plug pin 126 so that the antenna wire 128 becomes electrically connected to the antenna input of the radio receiver and amplifier circuit 14. In order to remove the assembly 118 from the receiver 10, the claws 124 are manually squeezed together, and to facilitate this the claws 124 may have protrusions 142 that can be squeezed together by a pair of pliers or a special tool. The plug 122 can then be withdrawn from the socket 134. If desired, a different lanyard and antenna assembly 118 can then be connected to the receiver 10, for example an assembly bearing different advertising material 132.

It should be noted that the embodiments of the invention have been described above purely by way of example and that many other modifications and developments may be made thereto within the scope of the present invention.

## Claims

1. A radio receiver (10) having means (20,22) operable by a user to change the reception frequency (r) to which the receiver is tuned and having first and second modes (50,48) of operation, selectable by the user, wherein, at least immediately after the first mode (50) is selected, the frequency changing means is operable in a defined manner by the user to tune the receiver to any desired frequency in a first band of reception frequencies and/or to the frequency of any desired signal being received in the first band of frequencies; and wherein, at least immediately after the second mode (48) is selected, the receiver is tuned to a preset frequency (*e*) outside of the first band; **characterised in that**, at least immediately after the second mode is selected, operation of the frequency changing means in the defined manner is ineffective.

2. A radio receiver as claimed in claim 1, wherein when the second mode is selected, the receiver cannot be tuned by the user to any frequency other than the preset frequency.

3. A radio receiver (10) having means (20,22) operable by a user to change the reception frequency (r) to which the receiver is tuned and having first and second modes (50,48) of operation, selectable by the user, wherein, at least immediately after the first mode (50) is selected, the frequency changing means is operable in a defined manner by the user to tune the receiver to any desired frequency in a first band of reception frequencies and/or to the frequency of any desired signal being received in the first band of frequencies; **characterised in that**, at least immediately after the second mode is selected, the frequency changing means is operable in the defined manner to tune the receiver to any one of a plurality of preset frequencies (44) at least one of which is outside of the first band.

4. A radio receiver as claimed in claim 3, wherein when the second mode is selected, the receiver cannot be tuned by the user to any frequency other than one of the plurality of preset frequencies.

5. A radio receiver as claimed in claim 3 or 4, wherein, when the second mode is selected, the receiver cannot be tuned by the user to at least one of the preset frequencies in accordance with an indication stored by the receiver.

6. A radio receiver as claimed in claim 4 or 5, wherein the frequency changing means comprises first and second elements (20,22) operable by the user, and the defined manner of operation of the frequency changing means comprises:
operating the first element (20) when the first mode (50) is selected to increase the reception frequency in the first band;
operating the second element (22) when the first mode (50) is selected to decrease the reception frequency in the first band; and
operating the first and second elements (20,22) when the second mode (48) is selected to change the selection of preset frequency.

7. A radio receiver as claimed in claim 6, wherein, when the second mode (48) is selected, the frequency changing means is operable in the defined manner to tune the receiver to more than two such preset frequencies, and the defined manner of operation of the frequency changing means includes:
operating the first element (20) when the second mode (48) is selected to change the selection of preset frequency in one sequence; and
operating the second element (22) when the second mode (48) is selected to change the selection of preset frequency in an opposite sequence.

8. A radio receiver as claimed in claim 6 or 7, wherein the selected mode can be changed by the user by operating both elements simultaneously.

9. A radio receiver as claimed in any preceding claim, and arranged so that, when the receiver is initially switched on, the second mode is initially selected.

10. A radio receiver as claimed in claim 9 when directly or indirectly dependent on claim 3, and arranged so that, when the receiver is initially switched on, the receiver is initially tuned to a predetermined one of the preset frequencies.

11. A radio receiver as claimed in any preceding claim, and arranged so that, when at least one of the modes is re-selected, the receiver is initially tuned to the frequency to which it was tuned when that mode was last selected.

12. A radio receiver as claimed in any preceding claim, wherein, when the second mode is selected, the receiver is operable to disable its output when a received signal has a signal strength less than a preset threshold.

13. A radio receiver as claimed in any preceding claim, wherein, when the second mode is selected, the receiver is operable to disable its output when a received signal does not include a particular code.

14. A radio receiver as claimed in any preceding claim, and which is provided by a radio receiver circuit (14) having an aerial input and a speaker output, wherein: the circuit is contained in a housing (12); a hooked element (34) extends from the housing for hanging the housing on a user's ear; a speaker (16) is contained in the housing and connected to the speaker output of the receiver circuit for directing sound at the user's ear when the housing is worn on the user's ear; a lanyard (116) extends from the housing by which the user can hold the receiver and/or hang the receiver around their neck; the lanyard forms or contains an aerial (30) connected to the aerial input of the receiver circuit; the lanyard and aerial are mechanically connected to the housing and electrically connected to the aerial input by a releasable connection (122,134) so that that lanyard and aerial can be removed from the housing and replaced by a different lanyard and aerial.

## Patentansprüche

1. Radioempfänger (10), der Folgendes aufweist: Mittel (20,22), die von einem Benutzer betätigt werden können, um die Empfangsfrequenz (r) zu ändern, auf die der Empfänger abgestimmt ist, und einen ersten und zweiten Betriebsmodus (50, 48), die von dem Benutzer ausgewählt werden können, wobei, mindestens unmittelbar nachdem der erste Modus (50) ausgewählt ist, das Frequenzänderungsmittel durch den Benutzer in definierter Weise betrieben werden kann, um den Empfänger auf Folgendes abzustimmen: eine beliebige gewünschte Frequenz in einem ersten Empfangsfrequenzband und/oder die Frequenz eines beliebigen gewünschten Signals, das in dem ersten Frequenzband empfangen wird; und wobei, mindestens unmittelbar nachdem der zweite Betriebsmodus (48) ausgewählt ist, der Empfänger auf eine voreingestellte Frequenz (e) außerhalb des ersten Bandes abgestimmt wird; **dadurch gekennzeichnet, dass** mindestens unmittelbar nachdem der zweite Modus ausgewählt ist, der Betrieb des Frequenzänderungsmittels in der definierten Weise unwirksam ist.

2. Radioempfänger nach Anspruch 1, wobei, wenn der zweite Modus ausgewählt ist, der Empfänger durch den Benutzer nicht auf eine andere Frequenz als die voreingestellte Frequenz abgestimmt werden kann.

3. Radioempfänger (10), der Folgendes aufweist: Mittel (20, 22), die durch einen Benutzer betätigt werden können, um die Empfangsfrequenz (r) zu ändern, auf die der Empfänger abgestimmt ist, und einen ersten und zweiten Betriebsmodus (50, 48), die von dem Benutzer ausgewählt werden können, wobei, mindestens unmittelbar nachdem der erste Modus (50) ausgewählt ist, das Frequenzänderungsmittel durch den Benutzer in definierter Weise betrieben werden kann, um den Empfänger auf Folgendes abzustimmen: eine beliebige gewünschte Frequenz in einem ersten Empfangsfrequenzband und/oder die Frequenz eines beliebigen gewünschten Signals, das in dem ersten Frequenzband empfangen wird; **dadurch gekennzeichnet, dass** mindestens unmittelbar nachdem der zweite Modus ausgewählt ist, das Frequenzänderungsmittel in der definierten Weise betrieben werden kann, um den Empfänger auf eine beliebige einer Vielzahl von voreingestellten Frequenzen (44) abzustimmen, von denen mindestens eine außerhalb des ersten Bandes liegt.

4. Radioempfänger nach Anspruch 3, wobei, wenn der zweite Modus ausgewählt ist, der Empfänger durch den Benutzer nicht auf eine andere Frequenz als eine der Vielzahl von voreingestellten Frequenzen abgestimmt werden kann.

5. Radioempfänger nach Anspruch 3 oder 4, wobei, wenn der zweite Modus ausgewählt ist, der Empfänger durch den Benutzer nicht auf mindestens eine der voreingestellten Frequenzen gemäß einem Hinweis, der von dem Empfänger gespeichert wurde, abgestimmt werden kann.

6. Radioempfänger nach Anspruch 4 oder 5, wobei das Frequenzänderungsmittel ein erstes und zweites Element (20, 22) umfasst, das durch den Benutzer betrieben werden kann, wobei die definierte Betriebsweise des Frequenzänderungsmittels Folgendes umfasst:
Betreiben des ersten Elements (20), wenn der erste Modus (50) ausgewählt ist, um die Empfangsfrequenz in dem ersten Band zu erhöhen;
Betreiben des zweiten Elements (22), wenn der erste Modus (50) ausgewählt ist, um die Empfangsfrequenz in dem ersten Band zu verringern; und
Betreiben des ersten und zweiten Elements (20, 22), wenn der zweite Modus (48) ausgewählt ist, um die Auswahl der voreingestellten Frequenz zu ändern.

7. Radioempfänger nach Anspruch 6, wobei, wenn der zweite Modus (48) ausgewählt ist, das Frequenzänderungsmittel in der definierten Weise dafür ausgelegt ist, den Empfänger auf mehr als zwei derartige voreingestellte Frequenzen abzustimmen, und wobei die definierte Betriebsweise des Frequenzänderungsmittels Folgendes umfasst:
Betreiben des ersten Elements (20), wenn der zweite Modus (48) ausgewählt ist, um die Auswahl der voreingestellten Frequenz in einer Sequenz zu ändern; und
Betreiben des zweiten Elements (22), wenn der zweite Modus (48) ausgewählt ist, um die Auswahl der voreingestellten Frequenz in einer entgegengesetzten Sequenz zu ändern; und

8. Radioempfänger nach Anspruch 6 oder 7, wobei der ausgewählte Modus durch den Benutzer durch Betätigen beider Elemente gleichzeitig geändert werden kann.

9. Radioempfänger nach einem der vorhergehenden Ansprüche, der so angeordnet ist, dass, wenn der Empfänger anfänglich eingeschaltet wird, der zweite Modus anfänglich ausgewählt wird.

10. Radioempfänger nach Anspruch 9, wenn direkt oder indirekt von Anspruch 3 abhängig, der so angeordnet ist, dass, wenn der Empfänger anfänglich eingeschaltet wird, der Empfänger anfänglich auf eine vorbestimmte der voreingestellten Frequenzen abgestimmt wird.

11. Radioempfänger nach einem der vorhergehenden Ansprüche, der so angeordnet ist, dass, wenn mindestens einer der Modi erneut ausgewählt wird, der Empfänger anfänglich auf die Frequenz abgestimmt wird, auf die er abgestimmt war, als der Modus zuletzt ausgewählt wurde.

12. Radioempfänger nach einem der vorhergehenden Ansprüche, wobei, wenn der zweite Modus ausgewählt ist, der Empfänger so betrieben werden kann, dass er seine Ausgabe sperrt, wenn ein empfangenes Signal eine Signalstärke aufweist, die geringer als ein voreingestellter Schwellenwert ist.

13. Radioempfänger nach einem der vorhergehenden Ansprüche, wobei, wenn der zweite Modus ausgewählt ist, der Empfänger so betrieben werden kann, dass er seine Ausgabe sperrt, wenn ein empfangenes Signal nicht einen bestimmten Code umfasst.

14. Radioempfänger nach einem der vorhergehenden Ansprüche, der von einer Radioempfängerschaltung (14) bereitgestellt wird, die einen Antenneneingang und einen Lautsprecherausgang aufweist, wobei: die Schaltung in einem Gehäuse (12) enthalten ist; ein Hakenelement (34) sich von dem Gehäuse zum Aufhängen des Gehäuses an dem Ohr eines Benutzers erstreckt; ein Lautsprecher (16) in dem Gehäuse enthalten ist und mit dem Lautsprecherausgang der Empfängerschaltung verbunden ist, zu Klang zu dem Ohr des Benutzers zu leiten, wenn das Gehäuse an dem Ohr des Benutzers getragen wird; eine Schlaufe (116) sich von dem Gehäuse erstreckt, an mit der der Benutzer den Empfänger halten und/oder den Empfänger um seinen Hals hängen kann; wobei die Schlaufe eine Antenne (30) bildet oder enthält, die mit dem Antenneneingang der Empfängerschaltung verbunden ist; wobei die Schlaufe und die Antenne mechanisch mit dem Gehäuse und elektrisch mit dem Antenneneingang durch eine lösbare Verbindung (122, 134) verbunden sind, so dass die Schlaufe und die Antenne aus dem Gehäuse entfernt und durch eine andere Schlaufe und Antenne ersetzt werden können.

## Revendications

1. Un récepteur radio (10) possédant un moyen (20, 22) actionnable par un utilisateur destiné à modifier la fréquence de réception (*r*) sur laquelle le récepteur est syntonisé et possédant un premier et un deuxième modes (50, 48) de fonctionnement sélectionnables par l'utilisateur, où, au moins immédiatement après que le premier mode (50) soit sélectionné, le moyen de modification de fréquence est actionnable d'une manière définie par l'utilisateur de façon à syntoniser le récepteur sur toute fréquence souhaitée dans une première bande de fréquences de réception et/ou sur la fréquence de tout signal souhaité qui est reçu dans la première bande de fréquences, et où, au moins immédiatement après que le deuxième mode (48) soit sélectionné, le récepteur est syntonisé sur une fréquence prédéfinie (e) à l'extérieur de la première bande, **caractérisé en ce que**, au moins immédiatement après le deuxième mode soit sélectionné, l'actionnement du moyen de modification de fréquence de la manière définie est inopérant.

2. Un récepteur radio selon la Revendication 1, où, lorsque le deuxième mode est sélectionné, le récepteur ne peut être syntonisé par l'utilisateur sur aucune fréquence autre que la fréquence prédéfinie.

3. Un récepteur radio (10) possédant un moyen (20, 22) actionnable par un utilisateur destiné à modifier la fréquence de réception (*r*) sur laquelle le récepteur est syntonisé et possédant un premier et un deuxième modes (50, 48) de fonctionnement sélectionnables par l'utilisateur, où, au moins immédiatement après que le premier mode (50) soit sélectionné, le moyen de modification de fréquence est actionnable d'une manière définie par l'utilisateur de façon à syntoniser le récepteur sur toute fréquence souhaitée dans une première bande de fréquences de réception et/ou sur la fréquence de tout signal souhaité qui est reçu dans la première bande de fréquences, **caractérisé en ce que**, au moins immédiatement après que le deuxième mode soit sélectionné, le moyen de modification de fréquence est actionnable de la manière définie de façon à syntoniser le récepteur sur une fréquence quelconque d'une pluralité de fréquences prédéfinies (44), au moins une d'elles étant à l'extérieur de la première bande.

4. Un récepteur radio selon la Revendication 3, où, lorsque le deuxième mode est sélectionné, le récepteur ne peut être syntonisé par l'utilisateur sur aucune fréquence autre qu'une fréquence de la pluralité de fréquences prédéfinies.

5. Un récepteur radio selon la Revendication 3 ou 4, où, lorsque le deuxième mode est sélectionné, le récepteur ne peut pas être syntonisé par l'utilisateur sur au moins une des fréquences prédéfinies conformément à une indication conservée en mémoire par le récepteur.

6. Un récepteur radio selon la Revendication 4 ou 5, où le moyen de modification de fréquence comprend un premier et un deuxième éléments (20, 22) actionnables par l'utilisateur et la manière de fonctionnement définie du moyen de modification de fréquence comprend :
l'actionnement du premier élément (20) lorsque le premier mode (50) est sélectionné de façon à augmenter la fréquence de réception dans la première bande,
l'actionnement du deuxième élément (22) lorsque le premier mode (50) est sélectionné de façon à diminuer la fréquence de réception dans la première bande, et
l'actionnement des premier et deuxième éléments (20, 22) lorsque le deuxième mode (48) est sélectionné de façon à modifier la sélection de la fréquence prédéfinie.

7. Un récepteur radio selon la Revendication 6, où, lorsque le deuxième mode (48) est sélectionné, le moyen de modification de fréquence est actionnable de la manière définie de façon à syntoniser le récepteur sur plus de deux desdites fréquences prédéfinies, et la manière de fonctionnement définie du moyen de modification de fréquence comprend :
l'actionnement du premier élément (20) lorsque le deuxième mode (48) est sélectionné de façon à modifier la sélection de la fréquence prédéfinie dans une séquence, et
l'actionnement du deuxième élément (22) lorsque le deuxième mode (48) est sélectionné de façon à modifier la sélection de la fréquence prédéfinie dans une séquence opposée.

8. Un récepteur radio selon la Revendication 6 ou 7, où le mode sélectionné peut être modifié par l'utilisateur par l'actionnement des deux éléments simultanément.

9. Un récepteur radio selon l'une quelconque des Revendications précédentes et agencé de sorte que, lorsque le récepteur est initialement mis sous tension, le deuxième mode est initialement sélectionné.

10. Un récepteur radio selon la Revendication 9 lorsqu'elle dépend directement ou indirectement de la Revendication 3, et agencé de sorte que, lorsque le récepteur est initialement mis sous tension, le récepteur est initialement syntonisé sur une fréquence prédéterminée des fréquences prédéfinies.

11. Un récepteur radio selon l'une quelconque des Revendications précédentes et agencé de sorte que, lorsqu'au moins un des modes est resélectionné, le récepteur est initialement syntonisé sur la fréquence à laquelle il a été syntonisé lorsque ce mode a été sélectionné en dernier lieu.

12. Un récepteur radio selon l'une quelconque des Revendications précédentes, où, lorsque le deuxième mode est sélectionné, le récepteur est conçu de façon à désactiver sa sortie lorsqu'un signal reçu possède une puissance de signal inférieure à un seuil prédéfini.

13. Un récepteur radio selon l'une quelconque des Revendications précédentes, où, lorsque le deuxième mode est sélectionné, le récepteur est conçu de façon à désactiver sa sortie lorsqu'un signal reçu ne contient pas un code particulier.

14. Un récepteur radio selon l'une quelconque des Revendications précédentes, et qui est fourni par un circuit récepteur radio (14) possédant une entrée antenne et une sortie haut-parleur, où : le circuit est contenu dans un logement (12), un élément à crochet (34) s'étend du logement destiné à accrocher le logement sur l'oreille d'un utilisateur, un haut-parleur (16) est contenu dans le logement et est raccordé à la sortie haut-parleur du circuit récepteur de façon à diriger un son vers l'oreille d'un utilisateur lorsque le logement est porté sur l'oreille d'un utilisateur, une courroie (116) s'étend à partir du logement grâce à laquelle l'utilisateur peut tenir le récepteur et/ou accrocher le récepteur autour de son cou, la courroie forme ou contient une antenne (30) raccordée à l'entrée antenne du circuit récepteur, la courroie et l'antenne sont raccordés mécaniquement au logement et raccordés électriquement à l'entrée antenne par une connexion libérable (122, 134) de sorte que la courroie et l'antenne puissent être retirées du logement et remplacées par une courroie et une antenne différentes.
